# EUROPÄISCHE PATENTANMELDUNG

(11) **EP 4 488 407 A1**
(43) Veröffentlichungstag der Anmeldung: **08.01.2025**
(21) Anmeldenummer: 24180511.8
(22) Anmeldetag: 06.06.2024
(51) Int. Cl.: C23C 16/448, C23C 16/455, C23C 16/52, C23C 16/54, G01F 22/02, G01F 25/10, G01F 25/17, C23C 16/04, C23C 16/40, G01F 25/00

(54) **VORRICHTUNG ZUR VERSORGUNG EINER BESCHICHTUNGSANLAGE MIT BENÖTIGTEN PROZESSGASEN UND VERFAHREN ZUM BETREIBEN EINER SOLCHEN GASVERSORGUNGSVORRICHTUNG**

(30) Priorität: 29.06.2023 DE 102023117131
(71) Anmelder: KHS GmbH, 44143 Dortmund (DE)
(72) Erfinder: Vogelsang, Andreas, 44143 Dortmund (DE); Kytzia, Sebastian, 44143 Dortmund (DE)
(74) Vertreter: Eisenführ Speiser

(57) **Zusammenfassung**

Die Erfindung betrifft Vorrichtungen (100) zur Versorgung einer Anlage (10) zur Beschichtung von Werkstücken (5) mit benötigten Prozessgasen für den auf der Anlage (10) ablaufenden Beschichtungsprozess, wobei die Vorrichtung wenigstens zwei Grundgasleitungen (124, 125; 102, 104) zum getrennten Führen von wenigstens zwei Grundgasen in einer Strömungsrichtung und wenigstens ein Mischmittel (171, 172, 173) zum Zusammenführen und Mischen von wenigstens zwei der Grundgase zu einem Gasgemisch aufweist. Zur dosierten Zuführung der Grundgase zum Mischmittel (171, 172, 173) ist in den Grundgasleitungen (102, 104; 124, 125) in der Strömungsrichtung der zugeführten Grundgase vor dem Mischmittel (171, 172, 173) jeweils ein Massflow-Controller (MFC; 141, 142, 143; 146, 147, 148) angeordnet, wobei die Vorrichtung zur Bereitstellung eines ersten Grundgases wenigstens einen Verdampfer (112, 114) aufweist, der eingerichtet und ausgebildet ist zur Überführung eines flüssigen Ausgangsfluides in den gasförmigen Zustand. Wenigstens der MFC (141, 142, 143), der das aus einem flüssigen Ausgangsfluid entstandene Grundgas dosiert zum Mischmittel (171, 172, 173) führt, ist auf einer kondensationsvermeidenden Temperatur größer oder gleich der Siedetemperatur gehalten ist. Erfindungsgemäß weist die Vorrichtung eine Referenzeinrichtung (180) auf, die ein Referenzvolumen bekannter Größe bereitstellt und die ebenfalls auf einer kondensationsvermeidenden Temperatur größer oder gleich der Siedetemperatur gehalten ist, wobei die Referenzeinrichtung (180) einen Drucksensor (190) zum Erfassen des Druckes in dem Referenzvolumen aufweist, wobei das Referenzvolumen über eine von einem schaltbaren Ventil (187) beherrschte Pumpleitung (185) an eine Pumpeinrichtung (160) zur Erzeugung eines Unterdrucks in dem Referenzvolumen angeschlossen ist, und wobei der auf der kondensationsvermeidenden Temperatur gehaltene MFC (141, 142, 143) über eine von einem schaltbaren Ventil (197) beherrschte Referenzleitung (195) an das Referenzvolumen angeschlossen ist.

## Beschreibung

Die Erfindung betrifft eine Vorrichtung nach dem Oberbegriff von Anspruch 1, insbesondere betrifft die Erfindung eine Vorrichtung zur Versorgung einer Anlage zur Beschichtung von Werkstücken mit für den auf der Anlage ablaufenden Beschichtungsprozess benötigten Prozessgasen, insbesondere zur Beschichtung von Innenwänden von Behältern. Bevorzugt sind diese Behälter Flaschen, insbesondere geht es um Behälter bzw. Flaschen aus Kunststoff, z.B. aus PET. Die Anlage zur Beschichtung führt die Beschichtung bevorzugt mittels eines PECVD-Verfahrens aus, insbesondere mittels eines mikrowelleninduzierten PECVD-Verfahrens. Die Erfindung betrifft auch eine Beschichtungsanlage mit einer solchen Gasversorgungsvorrichtung.

Die Erfindung betrifft darüber hinaus ein Verfahren nach dem Oberbegriff von Anspruch 10, insbesondere betrifft die Erfindung ein Verfahren zum Betreiben einer Vorrichtung zur Versorgung einer Anlage zur Beschichtung von Werkstücken wie oben genannt mit für den Beschichtungsprozess benötigten Prozessgasen. Insbesondere geht es um die Versorgung von Anlagen zur Beschichtung von Innenwänden von Behältern, insbesondere Flaschen, insbesondere mittels eines PECVD-Verfahrens, insbesondere mittels eines mikrowelleninduzierten PECVD-Verfahrens.

Gattungsgemäße Verfahren und Vorrichtungen sind z.B. aus der aus der EP 1 954 851 B1, der EP 1 113 089 A1, der JPH02-132821 oder der DE 102 58 681A1 für sehr unterschiedliche Beschichtungsanlagen bekannt. Dort ist gezeigt, dass und wie Grundgase durch Verdampfen entstehen und zu Gasmischungen zusammengeführt werden und wie dies in dosierter Weise unter Verwendung von MFC erfolgt. MFC ist eine übliche Abkürzung für Mass Flow Controller (Massendurchflussregler), die im Stand der Technik in vielfältiger Art bekannt sind und daher nicht detailliert beschrieben werden müssen. Ein MFC ist ein Gerät, mit dem ein Massenstrom auf einen Sollwert geregelt wird.

Ein besonderes Augenmerk liegt bei der vorliegenden Erfindung auf der Beschichtung von Behältern, z.B. von Flaschen, insbesondere auf der Innenbeschichtung von Behältern, insbesondere durch sogenannte PECVD-Verfahren, die grundsätzlich im Stand der Technik bekannt sind, z.B. aus der WO03/100125 A1, der WO03/100121 A2 oder der WO03/100120 A2. Die Beschreibung der Erfindung erfolgt primär mit Blick auf diese PECVD-Verfahren und mit Blick auf die Innenbeschichtung von Behältern z.B. aus PET, ohne dass damit aber eine Beschränkung beabsichtigt und verbunden ist. Auch diese PECVD-Verfahren und Anlagen, auf denen solche PECVD-Verfahren ablaufen, sind im Stand der Technik bekannt und bedürfen keiner detaillierten Beschreibung.

Für das Erreichen gewünschter Beschichtungen mit gewünschten Eigenschaften werden Prozessgase in dosierter Form Mischmitteln zugeführt. Diese Mischmittel können z.B. schlichte Kreuzungspunkte von zusammengeführten Leitungen sein, es kann sich dabei auch um durchmessererweiterte Leitungsbereiche handeln, in die Zuführungsleitungen einmünden. Das Zudosieren erfolgt dabei durch MFC, die in Leitungen für solche Grundgase angeordnet sind, die mit anderen Grundgasen zu Gasgemischen zusammengeführt und vermischt werden sollen. Solche MFC werden in aller Regel auf einen bestimmten Regelbereich und für ein bestimmtes Gas kalibriert.

Die Dosiergenauigkeit eines MFC kann mit der Zeit abnehmen bzw. die einmal vorgenommene Kalibrierung eines MFC kann mit der Zeit seine Validität verlieren. Daher ist grundsätzlich möglich, dass unbemerkt die einmal eingestellte Dosierleistung mit der Zeit nicht mehr zutrifft und also die erhaltene Gasmischung nicht mehr der intendierten Zusammensetzung entspricht, sodass auch die resultierende Beschichtung nicht mehr der intendierten Beschichtungsqualität entspricht. Es wäre grundsätzlich möglich, die Qualität der Beschichtungen messtechnisch zu prüfen, z.B. optisch, und die Dosierung an den MFC anzupassen. Es wäre grundsätzlich auch möglich, eine Untersuchung der erhaltenen Gasmischungen vorzunehmen und daraus Veränderungen an den MFC abzuleiten und diese neu einzustellen. Ebenfalls denkbar ist es, z.B. in regelmäßigen Abständen eine Kalibrierung der MFC erneut vorzunehmen. Alle diese aufgezeigten Möglichkeiten bedeuten aber einen sehr hohen Aufwand. Es wird insoweit als nachteilig angesehen, dass eine Aussage zur Dosierqualität der MFC nur mit größerem Aufwand erreichbar ist und daher eine Qualitätskontrolle der bereitgestellten Gasgemische nur mit großem Aufwand möglich erscheint. Die Untersuchung der sich ergebenden Beschichtungen lässt überdies keinen zuverlässigen Rückschluss zu, dass fehlerhafte Dosierung an den MFC ursächlich ist für festgestellte Abweichungen, denn der Beschichtungsvorgang selber hängt von weiteren Faktoren ab, z.B. von den Druckverhältnissen, von elektrischen Verhältnissen etc.

Es wird weiterhin als nachteilig angesehen, dass für Beschichtungsanlagen und Vorrichtungen zur Bereitstellung benötigter Prozessgase für solche Anlagen, die über eine längere Zeitdauer bei hohen Produktionsraten betrieben werden, keine einfachen Verfahren und Vorrichtungen zur Verfügung stehen, mit denen eine Aussage möglich ist, ob die MFC die gewünschte Dosierung in der gewünschten Weise leisten.

Der Erfindung liegt daher die Aufgabe zugrunde, eine verbesserte Lösung bereitzustellen, welche die genannten Probleme adressiert. Es ist insbesondere die Aufgabe der vorliegenden Erfindung, eine Vorrichtung der einleitend genannten Art derart bereitzustellen, das die Dosierung von MFC in qualitativer Hinsicht verbessern kann. Weiterhin sollen Vorteile bei der Überwachung von Vorrichtungen zur Bereitstellung von Prozessgasen erreicht werden.

Gemäß einem ersten Aspekt der Erfindung wird die Aufgabe gelöst durch eine Vorrichtung mit den kennzeichnenden Merkmalen von Vorrichtungsanspruch 1.

Gemäß diesem ersten Aspekt geht es um eine Vorrichtung zur Versorgung einer Beschichtungsanlage mit benötigten Prozessgasen für auf der Anlage ablaufende Beschichtungsprozesse. Hierzu weist die Vorrichtung wenigstens zwei Grundgasleitungen auf. Diese Grundgasleitungen dienen dem getrennten Führen von wenigstens zwei Grundgasen in einer Strömungsrichtung. Weiterhin sind Mischmittel vorgesehen zum Zusammenführen und Mischen von wenigstens zwei der Grundgase zu einem Gasgemisch. Die Grundgase können selber bereits ein Gemisch sein. Die Bezeichnung als Grundgas bedeutet insofern, dass vor dem Mischen in den Mischmitteln Ausgangsgase vorliegen und diese erst in den Mischmitteln zu Gasgemischen zusammengeführt werden, welche für einen nachfolgenden Beschichtungsprozess verwendet werden. Typische Grundgase können z.B. Sauerstoff, Stickstoff oder Argon sein, die bereits als Gas vorliegen und aus einer Gasquelle zugeführt werden. Das Grundgas kann aber auch durch Verdampfen flüssiger Komponenten entstehen, z.B. durch Verdampfen von HMDSN und/oder von HMDSO.

Für das Erhalten von Gasgemischen mit definierter und gewünschter Zusammensetzung sind in den Grundgasleitungen, die zum Mischmittel führen, jeweils MFC angeordnet. Diese MFC sind in Strömungsrichtung vor dem Mischmittel angeordnet und sorgen so für eine dosierte Zuführung der Grundgase zum Mischmittel.

Wenigstens eines der Grundgase soll aus einer flüssigen Ausgangskomponente gewonnen werden. Deshalb weist die Vorrichtung zur Bereitstellung eines ersten Grundgases wenigstens einen Verdampfer auf. Dieser Verdampfer ist eingerichtet und ausgebildet zur Überführung eines flüssigen Ausgangsfluides in den gasförmigen Zustand. Der Verdampfer weist hierzu insbesondere Heizmittel zum Erwärmen des Ausgangsfluides mindestens bis zu dessen Siedetemperatur auf, sodass das flüssige Ausgangsfluid in den gasförmigen Zustand überführt werden kann. Die Heizmittel werden z.B. so gesteuert bzw. geregelt, dass eine bestimmte Temperatur des Ausgangsfluides konstant erreicht wird. Verdampfer dieser Art oder ähnlicher Art sind im Stand der Technik bekannt.

Zur Vermeidung einer Kondensation des Grundgases, das aus einem solchen flüssigen Ausgangsfluid gewonnen wurde, wird auch der entsprechende zugeordnete MFC auf einer Temperatur größer oder gleich der Siedetemperatur des flüssigen Ausgangsfluides gehalten, sodass dieser MFC das in dem Verdampfer erzeugte Grundgas dosiert zum Mischmittel führen kann, ohne dass eine Kondensation des Gases diese Zudosierung beeinträchtigt. Bevorzugt ist der besagte MFC z.B. auf einer um mehrere °C, z.B. 5 °C, höheren Temperatur als der Siedetemperatur gehalten.

Im Unterschied zum gattungsbildenden Stand der Technik weist die erfindungsgemäße Vorrichtung eine Referenzeinrichtung auf, die ein Referenzvolumen bekannter Größe bereitstellt. Die Referenzeinrichtung ist ebenfalls auf einer kondensationsvermeidenden Temperatur größer oder gleich der Siedetemperatur gehalten, diese Temperatur ist z.B. identisch zu der Temperatur, auf die der MFC gehalten ist. Sinn und Zweck der Anordnung und des Vorhandenseins der Referenzeinrichtung ist es, die ordnungsgemäße Funktion des MFC oder gegebenenfalls auch mehrerer MFC zu überprüfen.

MFC werden in aller Regel auf einen bestimmten Regelbereich für ein bestimmtes Gas kalibriert. Zur Überprüfung dieser Kalibrierung und um ggf. Nacheinstellungen vorzunehmen, kann unter Zuhilfenahme der Referenzeinrichtung ein sogenannter Druckanstiegstest durchgeführt werden, aus dem dann die tatsächliche Gasmenge pro Zeiteinheit berechnet werden kann, die das überprüfte MFC zur Verfügung stellt. Die Referenzeinrichtung weist daher einen Drucksensor zum Erfassen des Druckes in dem Referenzvolumen auf, wobei das Referenzvolumen über eine von einem schaltbaren Ventil beherrschte Pumpleitung an eine Pumpeinrichtung zur Erzeugung eines Unterdrucks in dem Referenzvolumen angeschlossen ist, und wobei der auf der kondensationsvermeidenden Temperatur gehaltene MFC über eine von einem schaltbaren Ventil beherrschte Referenzleitung an das Referenzvolumen angeschlossen ist. Diese Referenzleitung ist zumindest teilweise unabhängig von den Grundgasleitungen ausgebildet und bevorzugt in der Strömungsrichtung der zugeführten Grundgase hinter dem MFC und vor dem Mischmittel angeordnet, z.B. indem zwischen dem MFC und dem Mischmittel die Referenzleitung von der Grundgasleitung abzweigt.

Unter Zuhilfenahme der erfindungsgemäßen Referenzeinrichtung kann ein Druckanstiegstest z.B. in festen zeitlichen Abständen oder zu festgelegten Anlässen ausgeführt werden. Möglichst ist auch, dass ein solcher Druckanstiegstest von einer Bedienperson ausgelöst werden kann, z. B. weil die Qualität erhaltener Beschichtungen auf ein Problem auf der Beschichtungsanlage hindeuten.

Ein solcher Druckanstiegstest kann wie folgt aussehen, um einen MFC zu überprüfen. Das Referenzvolumen wird zunächst von der Pumpeinrichtung abgepumpt auf einen bestimmten Unterdruck. Dazu wird das die Pumpleitung beherrschende Ventil in die Offenstellung geschaltet, alle übrigen Leitungen zum Referenzvolumen sind dabei geschlossen. Der Druck im Referenzvolumen wird z.B. von einer Druckmeßdose als Drucksensor gemessen. Hat der Druck im Referenzvolumen z.B. einen festgelegten Unterdruckwert erreicht oder ist das Referenzvolumen für einen bestimmten Zeitraum mit der Pumpeinrichtung verbunden gewesen, so schließt das Ventil in der Pumpleitung. Es wird dann Gas durch das zu prüfende MFC entlang der Referenzleitung und bei geöffnetem Schaltventil in der Referenzleitung in das Referenzvolumen hineingeführt. Es ist dabei keine andere zum Referenzvolumen führende Leitung geöffnet, sodass jede Druckänderung in dem Referenzvolumen ausschließlich durch einströmendes Gas verursacht ist, das über den zu prüfenden MFC zudosiert wird. Der Druck im Referenzvolumen wird über die Zeit gemessen und erfasst. Über die Druckverlaufskurve kann ermittelt werden, welches Volumen pro Zeit in das Testvolumen hineingeströmt ist, sodass auch der tatsächliche Fluss durch das MFC ermittelt werden kann. Stimmt dieser ermittelte tatsächliche Fluss mit dem am MFC eingestellten Sollfluss überein, arbeitet das MFC entlang der ursprünglichen Kalibrierung einwandfrei, anderenfalls ist eine Nacheinstellung erforderlich.

Die Präzision eines solchen Druckanstiegstest lässt sich optional noch verbessern, wenn zuvor eine Leckrate bestimmt wird. Ähnlich dem Druckanstiegstest wird nach dem Abpumpen für einen gewissen Zeitraum der Druckanstieg im Referenzvolumen ohne Gaszufluss beobachtet und ausgewertet. Der so berechnete Leckfluss wird dann vom später ermittelten MFC-Fluss abgezogen, um den realen Fluss durch das MFC zu erhalten.

Ein solcher Druckanstiegstest kann unter Verwendung des gleichen Referenzvolumens für mehrere MFC durchgeführt werden, wenn mehrere MFC über entsprechende Referenzleitungen an das gleiche Referenzvolumen angeschlossen sind. Der oben geschilderte Test kann also nacheinander für mehrere MFC durchgeführt werden. Soweit mehrere Referenzvolumina vorgesehen sind, kann der oben geschilderte Test zeitlich parallel unter Zuhilfenahme dieser mehreren Referenzvolumina durchgeführt werden, wenn die Zuordnung eines bestimmten MFC über eine bestimmte Referenzleitung mit einem Referenzvolumen gewährleistet ist, also jeweils nur ein einziges MFC mit einem einzigen Referenzvolumen verbunden ist, und ein gemessener Druckanstieg eindeutig einem bestimmten MFC und dessen Zudosierung gegenübergestellt werden kann.

Der Vorteil dieser Referenzeinrichtung mit einem bekannten Referenzvolumen ist also, dass eine Überprüfung erfolgen kann, ob die MFC noch in der ursprünglichen kalibrierten Weise die Dosierung der Grundgase leisten, ohne dass hierfür die MFC ausgebaut und/oder neu kalibriert werden müssten. Der Vorteil, auch die Referenzeinrichtung auf einer kondensationsvermeidenden Temperatur zu halten, besteht in einer höheren Messgenauigkeit, weil anderenfalls Kondensationsvorgänge den Druckanstiegstest verfälschen.

Eine sinnvolle und somit bevorzugte Größe für das Referenzvolumen hängt von mehreren Faktoren ab. Das Referenzvolumen soll eine Druckanstiegsmessung ermöglichen, somit soll das Referenzvolumen zu einem sinnvollen Messbereich führen. Dies hängt von einem typischen Durchfluss durch das MFC ab, das geprüft werden soll. Ist dieser Durchfluss groß, sollte auch das Testvolumen relativ groß sein, um während des Druckanstiegstests über eine ausreichend lange Zeit eine Druckveränderung messen zu können. Ist die Durchflussmenge durch das MFC klein, wäre dies auch mit einem kleineren Volumen möglich. Will man nur ein einziges Referenzvolumen für mehrere MFC mit unterschiedlichen Durchflussmengen bereitstellen, muss dieses Volumen insofern ein Kompromiss sein, der für alle MFC noch zu einem sinnvollen Messbereich führt. Dem Fachmann ist aufgrund dieser Erklärung die Wahl eines geeigneten Volumens unproblematisch möglich und der Fachmann erkennt, dass ein geeignetes Volumen immer noch in weiten Grenzen wählbar ist. Bei typischen PECVD-Beschichtungsanlagen z.B. für Behälter ist z.B. ein Referenzvolumen von 5 Litern eine geeignete Größe, ein kleineres Volumen von z.B. 1 Liter oder ein größeres Volumen von z.B. 10 Liter ergeben aber immer noch einen sinnvollen Messbereich z.B. für MFC zwischen 100 sccm bis zu mehreren 1000 sccm. Die konkrete Wahl der Größe des Referenzvolumens hängt auch davon ab, wie exakt der Druckanstiegstest ausfallen soll und wie viel Zeit für einen solchen Druckanstiegstest zur Verfügung gestellt werden kann.

Die Ausführung eines solchen Druckanstiegstests kann z.B. zu festen Ereignissen stattfinden, also z.B. bei jedem Start der erfindungsgemäßen Vorrichtung. Der Test kann z.B. auch durchgeführt werden, wenn es zu Unterbrechungen in der Produktion kommt. Denkbar ist auch, dass ein Test durchgeführt wird, sobald eine bestimmte Produktionsbetriebsdauer erreicht ist, z.B. alle 12 Produktionsstunden, gegebenenfalls könnte dieses Erreichen auch einer Bedienperson angezeigt werden und diese Bedienperson kann dann den Test auslösen, sobald ein geeigneter Zeitpunkt erreicht ist. Denkbar ist auch, dass eine Bedienperson immer dann einen solchen Test ausführt, wenn die Bedienperson dies für sinnvoll erachtet. Weitere ereignisorientierte oder andere zeitorientierte Auslöser für Druckanstiegstests sind denkbar.

Das Ergebnis des Tests könnte z.B. einfach einer Bedienperson angezeigt werden, eine Aufzeichnung der Ergebnisse ist ebenfalls möglich, z.B. als Qualitätsaussage, dass die bereitgestellten Prozessgase in bestimmter Zusammensetzungsqualität vorgelegen haben. Denkbar ist auch, dass bei Feststellung einer Abweichung in dem Test, z.B. einer Abweichung, die bestimmte Toleranzgrenzen überschreitet, eine Warnung ausgegeben oder angezeigt wird, und z.B. ein Eingriff als erforderlich angezeigt wird. Denkbar ist auch, dass automatisch eine Einstellung an einem MFC angepasst wird, um die Abweichung zu beseitigen. Ergibt der Test z.B., dass ein MFC eine Zudosierung in zu geringer Menge vornimmt, könnte der Öffnungsquerschnitt am MFC erhöht werden.

Eine weitere Aufgabe der vorliegenden Erfindung ist es insbesondere, ein Verfahren der einleitend genannten Art fortzubilden. Es sollen Vorteile bei der Bereitstellung von Prozessgasen erreicht werden, insbesondere bei der dosierten Zuführung von Grundgasen zur Erzeugung der Prozessgase.

Gemäß einem weiteren Aspekt der Erfindung wird diese genannte Aufgabe erfindungsgemäß gelöst durch ein Verfahren mit den kennzeichnenden Merkmalen von Verfahrensanspruch 10.

Eigenschaften und Vorteile der Erfindung entsprechend dabei im Wesentlichen denen, die zur erfindungsgemäßen Vorrichtung erläutert worden sind.

Vorteilhafte Ausgestaltungen der Vorrichtung und des Verfahrens sind in den jeweiligen Unteransprüchen angegeben. Die nachfolgend diskutierten bevorzugten Ausführungsformen der Vorrichtung finden sich spiegelbildlich auch in dem Verfahren wieder. Umgekehrt finden sich die nachfolgend diskutierten bevorzugten Ausführungsformen des Verfahrens spiegelbildlich auch in der Vorrichtung wieder. Die jeweils angegebenen Vorteile des Verfahrens bzw. der Vorrichtung sind spiegelbildlich auch Vorteile der Vorrichtung bzw. des Verfahrens.

Bezüglich der Vorrichtung wird mit Vorteil vorgeschlagen, dass diese zur Bereitstellung von zwei oder mehr Grundgasen zwei oder mehr Verdampfer aufweist, die jeweils eingerichtet und ausgebildet sind zur Überführung eines flüssigen Ausgangsfluides in den gasförmigen Zustand. Die jeweiligen Verdampfer weisen hierzu in bekannter Weise insbesondere Heizmittel zum Erwärmen des jeweiligen Ausgangsfluides mindestens bis zur jeweiligen Siedetemperatur auf. Diesen aus flüssigen Ausgangsfluiden entstandenen Grundgasen ist jeweils wenigstens ein MFC zugeordnet, der jeweils an eine Referenzeinrichtung mit den Eigenschaften des Kennzeichens von Anspruch 1 angeschlossen ist. Dies umfasst die Möglichkeit, dass mehrere Referenzeinrichtungen vorgesehen sind, z.B. pro MFC eine zugeordnete Referenzeinrichtung. Dadurch könnten alle MFC zeitgleich in der oben beschriebenen Art überprüft werden. Bevorzugt ist allerdings, dass mehrere MFC der gleichen Referenzeinrichtung zugeordnet und an dieser angeschlossen sind, sodass in der oben beschriebenen Art die mehreren MFC zeitlich nacheinander überprüft werden können. Es ist dabei auch möglich, dass mehrere Referenzeinrichtungen vorgesehen sind und jeder Referenzeinrichtung dennoch mehrere MFC zugeordnet bzw. an dieser angeschlossen sind. Es könnte z.B. unterschieden werden, ob ein MFC ein aus einem flüssigen Ausgangsfluid entstandenes Grundgas zudosiert (MFC der ersten Art) oder ein schon in gasförmiger Form bereitgestelltes Grundgas zudosiert (MFC der zweiten Art) und eine Referenzeinrichtung für die eine Art von MFC und eine Referenzeinrichtung für die andere Art von MFC vorgesehen wird. Dies wäre insofern vorteilhaft, als die den schon gasförmig zugeführten Grundgasen zugeordnete Referenzeinrichtung unproblematisch im Hinblick auf Kondensation ist und also z.B. nicht auf eine erhöhte Temperatur gehalten werden muss zur Vermeidung einer Kondensation.

Umgekehrt betrachtet ist es vorteilhaft, mehrere Referenzeinrichtungen vorzusehen und jede Referenzeinrichtung nur an MFC einer bestimmten Art anzuschließen: entweder handelt es sich bei den MFC allesamt um solche, die Grundgase zudosieren, die aus gasförmig bereitgestellten Gasen zugeführt werden, oder allesamt um solche MFC, die aus flüssigen Ausgangsfluiden verdampfte Grundgase zudosieren. Die Vorteile sind wie vorstehend angegeben.

Wenn mehrere Grundgase durch Verdampfen eines flüssigen Ausgangsfluides erzeugt werden, und die zugeordneten MFC an eine gemeinsame Referenzeinrichtung angeschlossen sind, und wenn weiterhin die Siedetemperaturen der Ausgangsfluide unterschiedlich sind, ist die Referenzeinrichtung bevorzugt mindestens auf die höhere der Siedetemperaturen zu bringen, gegebenenfalls einige Grad höher, z.B. 5 °C höher.

Das Halten der MFC und/oder der Referenzeinrichtung auf eine kondensationsvermeidende Temperatur könnte so ausgeführt werden, dass jeweils Temperiereinrichtungen zugeordnet sind und also die MFC temperiert werden und die Referenzeinrichtung temperiert wird. Soweit mehrere Referenzeinrichtungen zu temperieren sind, könnte jede für sich mit einer Temperiereinrichtung versehen und jede für sich temperiert werden. Bevorzugt ist allerdings, dass die Vorrichtung einen von Wänden umgebenen Warmbereich aufweist, der auf einer kondensationsvermeidenden Temperatur größer oder gleich der Siedetemperatur gehalten ist. Falls es mehr als eine Siedetemperatur gibt, die zu berücksichtigen ist, ist die Referenzeinrichtung bevorzugt mindestens auf die höhere der Siedetemperaturen zu bringen, also auch der Warmbereich mindestens auf der höheren der Siedetemperaturen gebracht, gegebenenfalls einige Grad höher, z.B. 5 °C höher. Indem zu temperierende MFC und zu temperierende Referenzeinrichtungen in diesem Warmbereich angeordnet werden, sind dadurch alle zu temperierenden Elemente gemeinsam auf einer kondensationsvermeidenden Temperatur zu halten, indem der Warmbereich temperiert wird und auf einer kondensationsvermeidenden Temperatur gehalten ist. Dies ist vorzugswürdig gegenüber einer Einzeltemperierung der betroffenen MFC und/oder Referenzeinrichtungen.

Soweit ein aus einer Gasquelle bereitgestelltes Grundgas durch ein MFC zudosiert wird, wird als vorteilhaft angesehen, das entsprechende MFC an eine Referenzeinrichtung anzuschließen und diese Referenzeinrichtung sowie das besagte MFC außerhalb des genannten Warmbereiches anzuordnen bzw. beide ohne Temperierung auszubilden. Der Bauraum des Warmbereiches kann dadurch verringert werden. Verallgemeinert kann gesagt werden, dass MFC und zugeordnete Referenzeinrichtung auf eine gleiche Temperatur gebracht werden sollten. Zu temperierende MFC sollten einer zu temperierenden Referenzeinrichtung zugeordnet sein und nicht zu temperierende MFC sollten einer nicht zu temperierenden Referenzeinrichtung zugeordnet sein. Entsprechend sollten MFC und zugeordnete Referenzeinrichtung beide innerhalb oder beide außerhalb des Warmbereichs angeordnet sein. Ein MFC bzw. eine Referenzeinrichtung werden dann als zu temperieren bezeichnet, wenn diese auf eine kondensationsvermeidende Temperatur zu bringen sind. "Temperieren" meint das Einstellen einer Temperatur durch Erwärmen, die eine solche Kondensation verhindert.

Mit Vorteil ist vorgesehen, dass Steuerelektroniken von MFC, die auf eine kondensationsvermeidende Temperatur zu bringen sind und die dazu z.B. in einem Warmbereich angeordnet werden, außerhalb des Warmbereiches angeordnet sind, Verallgemeinert ausgedrückt sind die Steuerelektroniken ohne Temperierung ausgeführt, da sie entfernt von den temperierten MFC angeordnet werden. Diese Maßnahme erhöht die Lebensdauer der entsprechenden Steuerelektroniken bzw. ermöglicht die Verwendung von Steuerelektroniken, die nicht unter Erhöhung der Kosten für Verwendung in einem Warmbereich ausgeführt sein müssen.

Für eine zuverlässige Verdampfung des flüssigen Ausgangsfluides ist bevorzugt, dass der Verdampfer oder jeder der Verdampfer ausgebildet ist, das Ausgangsfluid mindestens auf 10 °C, bevorzugt mindestens 15 °C und weiter bevorzugt mindestens 20 °C oberhalb dessen Siedetemperatur aufzuheizen, wobei die kondensationsvermeidende Temperatur im Warmbereich bevorzugt wenigstens 5 °C oberhalb dieser Aufheiztemperatur gehalten ist.

Eine erfindungsgemäße Vorrichtung kann z.B. zur Ausübung eines der in den Verfahrensansprüchen angegebenen Verfahren ausgebildet und eingerichtet sein.

Eine bevorzugte Anwendung findet eine erfindungsgemäße Vorrichtung in Anlagen zur Beschichtung von Werkstücken, insbesondere zur Beschichtung von Innenwänden von Behältern, insbesondere von Flaschen. Insbesondere ist an die Innenbeschichtung von Flaschen aus einem Kunststoff gedacht, insbesondere aus einem thermoplastischem Kunststoff, insbesondere aus PET. Bevorzugt werden auf der Anlage Beschichtungen mittels eines PECVD-Verfahrens abgeschieden, insbesondere mittels eines mikrowelleninduzierten PECVD-Verfahrens. Diese Anlagen weisen eine wie vorstehend beschriebene Gasversorgungsvorrichtung auf, welche die für den Beschichtungsprozess benötigten Prozessgase bereitstellt.

Eine vorteilhafte Ausführungsform eines erfindungsgemäßen Verfahrens sieht z.B. vor, dass die Gasversorgungsvorrichtung nach irgendeiner der vorstehenden Varianten in wenigstens zwei unterschiedlichen Betriebsmodi betrieben wird. Ein erster Betriebsmodus ist ein Produktionsmodus, in dem die Referenzeinrichtung oder -einrichtungen nicht mit Gas beaufschlagt werden, aber Werkstücke beschichtet werden. Entsprechend sind zur Referenzeinrichtung führende Ventile geschlossen, sodass über Referenzleitungen kein Gas zur Referenzeinrichtung gelangt. Ein zweiter Betriebsmodus ist ein Referenzmodus, in dem keine Werkstücke beschichtet werden, aber die Referenzeinrichtung mit Gas beaufschlagt wird, indem die dahinführenden Referenzleitungen nicht mehr dauerhaft geschlossen sind, sondern zur Ausführung einer Druckanstiegsmessung geeignet geöffnet und geschlossen werden. Mindestens in diesem Referenzmodus ist auch die Pumpeinrichtung zeitweilig mit der Referenzeinrichtung verbunden und es erfolgt ein Einstellen eines Unterdruckes in der Referenzeinrichtung. Es ist möglich, dass auch im Produktionsmodus diese Verbindung besteht bzw. bereits im Produktionsmodus ein Unterdruck in der Referenzeinrichtung eingestellt wird mit dem Vorteil, dass bei einem Übergang in den Referenzmodus gleich eine Druckanstiegsmessung ausführbar ist, da in der Referenzeinrichtung bereits Unterdruckbedingungen bestehen.

Die erfindungsgemäße Vorrichtung ermöglicht eine Verfahrensvariante, bei der die Volumina der zur Beschichtungsanlage verlaufenden prozessgasführenden Leitungen, ggf. auch in der Anlage zu den Beschichtungskammern führende Leitungen bestimmt werden, indem eine Druckanstiegsmessung in zu den Beschichtungskammern hin verschlossene Prozessgasleitungen hinein ausgeführt wird. Dazu bedarf es Drucksensoren, die den Druck in prozessgasführenden Leitungen erfassen können. Weiterhin bedarf es dazu Unterdruckbedingungen in diesen prozessgasführenden Leitungen. Schließlich ist durch Öffnen und Schließen der geeigneten Ventile sicherzustellen, dass in die zu prüfenden prozessgasführenden Leitungen ausschließlich Gas über einen bestimmten MFC in ein abgeschlossenes Volumen hineinströmt und dieser MFC eine bekannte Durchflussrate aufweist, z.B. zuvor durch eine Kalibrierung oder eine zuvor ausgeführte Druckanstiegsmessung in eine Referenzeinrichtung hinein festgestellt. Das so ermittelte Volumen kann z.B. verglichen werden mit einer früheren, solchen Messung, insbesondere mit einer Messung bei der Inbetriebsetzung bzw. Errichtung der Anlage. Auf diese Weise lässt sich ermitteln, ob prozessgasführende Leitungen durch Abscheideprozesse kritische Verschmutzungsgrade erreichen und z.B. ein Reinigungsprozess der Leitungen erforderlich ist.

Nachfolgend wird die Erfindung anhand von bevorzugten Ausführungsbeispielen und anhand der beiliegenden Figuren näher erläutert. Die Zeichnungen sind nicht unbedingt maßstabsgetreu. In den Figuren sind gleiche oder im Wesentlichen funktionsgleiche bzw. -ähnliche Elemente mit den gleichen Bezugszeichen bezeichnet. Es zeigen:
- Fig. 1: eine schematische Aufsicht auf eine Beschichtungsanlage, wie sie im Grundaufbau und grundsätzlich im Stand der Technik bekannt ist;
- Fig. 2: eine perspektivische Ansicht auf ein erstes Beispiel für eine vereinzelte Beschichtungsstation;
- Fig. 3: eine Schnittansicht durch ein zweites Beispiel für eine vereinzelte Plasmastation mit Doppelkammer;
- Fig. 4: eine perspektivische Ansicht auf eine erfindungsgemäße Gasversorgungsvorrichtung für eine Beschichtungsvorrichtung;
- Fig. 5: eine Prinzipskizze zu den Vorgängen in einer erfindungsgemäßen Gasversorgungsvorrichtung am Beispiel von zwei Trägergasen und zwei Grundgasen, die durch Verdampfen von Monomeren bereitgestellt werden;
- Fig. 6: eine Prinzipdarstellung zu einem Verfahrensablauf einer Druckanstiegsmessung.

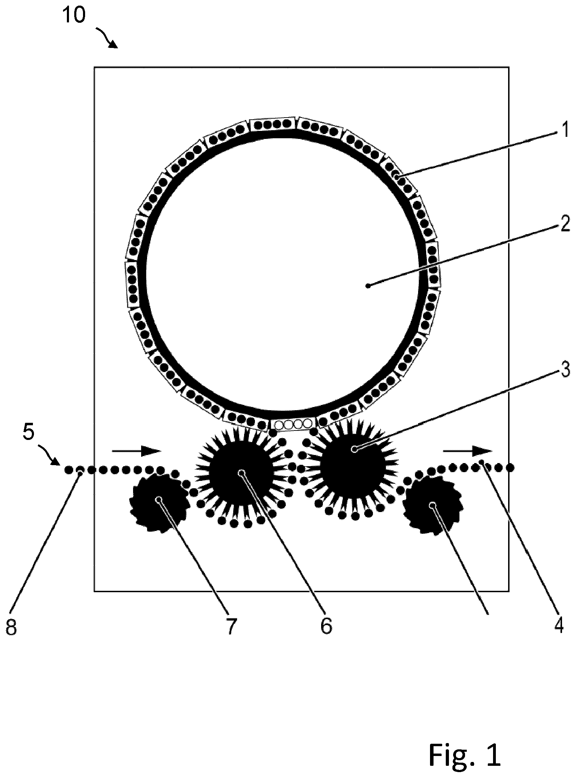

Aus der Darstellung in Fig. 1 ist eine Beschichtungsanlage, genauer gesagt eine PECVD-Anlage 10 zu erkennen, die mit einem rotierenden Plasmarad 2 versehen ist. Entlang eines Umfanges des Plasmarades 2 sind umfangsbeabstandet eine Mehrzahl von Plasmastationen 1 angeordnet. Die Plasmastationen 1 sind mit später noch gezeigten Kavitäten bzw. Plasmakammern 17 zur Aufnahme von zu behandelnden Werkstücken 5 versehen. Beispielhaft ist gezeigt, dass jede Plasmastation vier Behandlungsplätze aufweist. Diese PCVD-Anlage 10 steht rein exemplarisch für alle Beschichtungsanlagen, die unter Zuführung von Prozessgasen Beschichtungsprozesse ausführen. Weiterhin werden nachfolgend die Werkstücke lediglich beispielhaft von Behältern gebildet.

Die zu behandelnden Behälter 5 werden dem Plasmarad 2 im Bereich einer Eingabe 8 zugeführt und über ein Vereinzelungsrad 7 an ein Übergaberad 6 weitergeleitet, das mit Tragarmen ausgestattet ist, die z.B. positionierbar ausgeführt sein können. Die Tragarme können z.B. relativ zu einem Sockel des Übergaberades 6 verschwenkbar angeordnet sein, so daß eine Abstandsveränderung der Behälter 5 relativ zueinander durchgeführt werden kann. Hierdurch erfolgt eine Übergabe der Behälter 5 vom Übergaberad 6 an das Plasmarad 2. Nach einer Durchführung der Behandlung während des Umlaufes auf dem Plasmarad 2 werden die behandelten Behälter 5 von einem Ausgaberad 3 aus dem Bereich des Plasmarades 2 entfernt und in den Bereich einer Ausgabestrecke 4 überführt.

Es sind im Stand der Technik die beiden Möglichkeiten bekannt, die z.B. als Behälter ausgebildeten Werkstücke 5 mit Mündungsbereich nach oben oder nach unten weisend zu beschichten. Da der Transport der Behälter 5 einfacher ist, wenn der Mündungsbereich nach oben weist, könnte z.B. die Zuführung der Behälter 5 im Bereich der Eingabe 8 mit Mündungsbereich nach oben weisend erfolgen und z.B. auf dem Übergaberad 6 der Behälter 5 gewendet werden in eine Positionierung mit Mündungsbereich nach unten. Arbeitsräder mit einer solchen Wendefunktion sind im Stand der Technik bekannt. In dieser Positionierung würde die Übergabe der Behälter 5 auf das Plasmarad 2 erfolgen und auch die Entnahme vom Plasmarad 2 nach erfolgter Behandlung. Das Ausgaberad 3 könnte dann erneut ein Wenden des Behälters 5 vornehmen und der Behälter 5 anschließend mit einer Positionierung mit Mündung nach oben der Ausgabestrecke 4 zugeführt werden. Ohne Beschränkung der Allgemeinheit wird in nachfolgenden Abbildungen eine Positionierung des Behälters 5 mit Mündungsbereich nach unten weisend gezeigt. Möglich ist natürlich auch, dass die Behandlung auf dem Plasmarad mit Mündungsbereich nach oben weisenden erfolgt und kein Wendevorgang vor und nach dem Plasmarad ausgeführt wird.

In nicht dargestellter Weise, weil im Stand der Technik hinreichend bekannt, werden den mit dem Plasmarad 2 umlaufenden Plasmastationen 1 die für den Beschichtungsprozess notwendigen Prozessgase zugeführt. Die Zuführung erfolgt in der Regel in einem Zentrum des Plasmarades 2 und über einen dort angeordneten Drehverteiler, über den die Plasmastationen 1 auch mit weiteren Betriebsmitteln sowie Energie versorgt werden. Zur Betriebsmittelverteilung werden insbesondere Ringleitungen eingesetzt. Die auf das Plasmarad 2 übergebenen Prozessgase liegen bei der Übergabe in der erforderlichen Zusammensetzung vor und werden von einer außerhalb des Plasmarades 2 angeordneten Gasversorgungsvorrichtung bereitgestellt, die später beschrieben wird und die den eigentlichen Gegenstand der Erfindung darstellt.

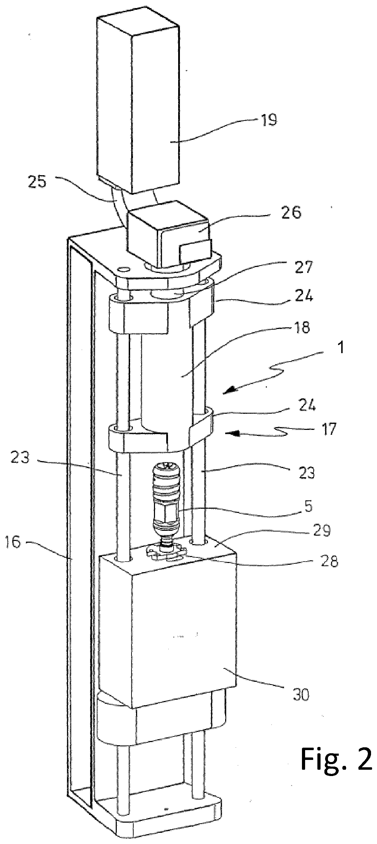

In Fig. 2 ist zur Erläuterung eines möglichen grundsätzlichen Aufbaus einer Plasmastation 1 in perspektivischer Darstellung eine Station mit einem Einzelbehandlungsplatz gezeigt. Ein Stationsrahmen 16 ist mit Führungsstangen 23 versehen, auf denen ein Schlitten 24 zur Halterung der zylinderförmigen Kammerwandung 18 geführt ist. Fig. 2 zeigt den Schlitten 24 mit Kammerwandung 18 in einem angehobenen Zustand, so daß das auf dem Kopf stehende Werkstück in Form eines Behälters 5 freigegeben ist.

Im oberen Bereich der Plasmastation 1 ist ein Mikrowellengenerator 19 angeordnet. Der Mikrowellengenerator 19 ist über eine Umlenkung 25 und einen Adapter 26 an einen Kopplungskanal 27 angeschlossen, der in die Plasmakammer 17 einmündet. Der Adapter 26 hat die Funktion eines Übergangselementes. Die Umlenkung 25 ist als ein Hohlleiter ausgebildet. Der Behälter 5 wird im Bereich eines Dichtelementes 28 positioniert, das im Bereich eines Kammerbodens 29 angeordnet ist. Der Kammerboden 29 ist als Teil eines Kammersockels 30 ausgebildet.

Zum Schließen der Plasmakammer 17 kann der Schlitten 24 mit der zylinderförmigen Kammerwandung 18 entlang der Schienen 23 abgesenkt werden, bis die Kammerwandung 18 gegen den Kammerboden 29 gefahren ist. In diesem geschlossenen Positionierzustand kann die Plasmabeschichtung des dann in der geschlossenen Kavität 17 eingeschlossenen Behälters 5 durchgeführt werden. Im geschlossenen Positionierzustand erfolgt auch das Einstellen des in der Kammer 17 und des im Behälter 5 erforderlichen Unterdruckes, um ein Plasma zu erzeugen und mikrowelleninduziert die Plasmabeschichtung vorzunehmen.

In der in Fig. 2 gezeigten angehobenen Positionierung der Kammerwandung 18 ist es ohne Probleme möglich, den behandelten Behälter 5 aus dem Bereich der Plasmastation 1 zu entfernen und einen neuen zu behandelnden Behälter 5 einzusetzen, z.B. mittels der in Figur 1 gezeigten Räder 6 und 3.

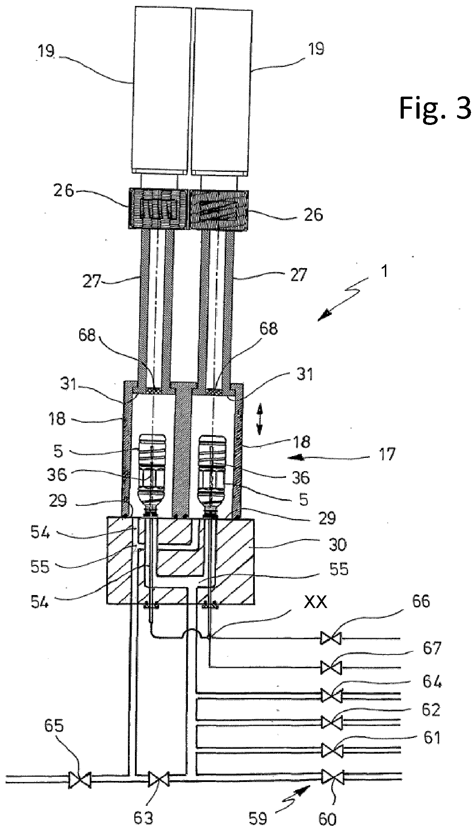

Fig. 3 zeigt ein alternatives Beispiel für eine Plasmastation 1 mit zwei Plasmakammern 17 zur gleichzeitigen Plasmabehandlung von zwei Behältern 5. Jede der Plasmakammern 17 ist über einen Kopplungskanal 27 sowie einen Adapter 26 und eine Umlenkung 25 an jeweils einen Mikrowellengenerator 19 angeschlossen. Grundsätzlich ist es ebenfalls denkbar, für zwei oder mehr Plasmakammern 17 einen gemeinsamen Mikrowellengenerator 19 zu verwenden und über eine nicht dargestellte Verzweigung eine Aufteilung der generierten Mikrowellenstrahlung vorzunehmen, um eine gleichmäßige Zündung des Plasmas in jeder der Plasmakammern 17 zu gewährleisten.

In die Plasmakammern 17 münden Kopplungskanäle 54 ein, die jeweils an eine Verzweigung 55 zur Aufteilung einer Menge eines zugeführten Betriebsmittels in zwei Teilmengen angeschlossen sind. Bei einer Verwendung von mehr als zwei Plasmakammern 17 wird die Verzweigung 55 entweder mit einer entsprechenden Anzahl von Ausgängen versehen, oder es werden kaskadiert mehrere Teilverzweigungen hintereinander angeordnet. Über diese Kanäle 54, 55 kann z.B. Unterdruck zugeführt werden.

Zusätzlich eingezeichnet ist eine Gaslanze 36, die in vertikaler Richtung in den Behälter 5 hineingefahren und herausgeführt werden kann, z.B. in nicht dargestellter Weise durch Anordnung an einem Lanzenschlitten, der in vertikaler Richtung geführt und z.B. kurvengesteuert eine Vertikalbewegung ausführen kann. In der dargestellten Positionierung ist die Plasmakammer 17 geschlossen und die Lanze 36 innerhalb des Behälters 5 angeordnet für das Austragen der Prozessgase in den Innenraum des Behälters 5.

Im Bereich des Kammersockels 30 erfolgt über die schon angesprochenen Kanäle 54, 55 die Beaufschlagung der Plasmakammern 17 und der Behälter 5 mit Unterdruck. Prozessgase werden über eine Leitung 66 der Gaslanze 36 zugeführt und in das Behälterinnere geleitet. Die Zuführung all dieser Betriebsmittel erfolgt ventilgesteuert. Die Leitung 66 steht in Verbindung mit einer Gasversorgungsvorrichtung und führt die von dieser Gasversorgungsvorrichtung bereitgestellten Prozessgase zur Gaslanze 36.

Fig. 3 zeigt in einer stark schematisierten Darstellung sowie mit zusätzlicher Darstellung von Ventilen 59 die Steuerung einer Betriebsmittelzufuhr. Beim dargestellten Ausführungsbeispiel sind aufgrund der schaltungstechnischen Anordnung der Kopplungskanäle 54 drei Verzweigungen 55 verwendet. Zu erkennen sind ebenfalls Quarzglasfenster 68 zur Abdichtung der Innenräume der Plasmakammern 17 relativ zu den Innenräumen der Kopplungskanäle 27 bei gleichzeitiger Durchtrittsmöglichkeit für die Mikrowellenstrahlung.

Gemäß der gezeigten, rein beispielhaften Ausführungsform werden ein Primärvakuumventil 60 zur Zuführung einer ersten Unterdruckstufe sowie ein Sekundärvakuumventil 61 zur Zuführung eines gegenüber der ersten Unterdruckstufe niedrigeren Unterdruckes verwendet. Das Hinzutreten weiterer Unterdruckstufen ist möglich. Zur Aufrechterhaltung des Vakuums synchron zur Zuführung des Prozessgases ist darüber hinaus ein Prozessvakuumventil 62 angeordnet. Das Prozessvakuumventil 62 vermeidet einen Übertritt von abgesaugtem Prozessgas in die Versorgungskreise für das Primärvakuum und das Sekundärvakuum.

Zur Unterstützung einer wahlweisen oder gemeinsamen Zuführung von Unterdruck zum Innenraum des Behälters 5 und/oder in den weiteren Innenraum der Plasmakammer 17 ist ein Kammervakuumventil 63 verwendet, das eine entsprechende Absperrfunktion durchführt. Insbesondere ist daran gedacht, das jeweilige Versorgungsvakuum über die Ventile 60, 61, 62 jeweils unmittelbar dem Innenraum des Behälters 5 zuzuführen und über das Kammervakuumventil 63 gesteuert eine bedarfsabhängige Zuschaltung des weiteren Innenraumes der Plasmakammer 17 vorzunehmen.

Für eine vorgebbare und voneinander unabhängige Entlüftung sowohl des Innenraumes des Behälters 5 als auch des weiteren Innenraumes der Plasmakammer 17 wird ein Behälterentlüftungsventil 64 sowie ein Kammerentlüftungsventil 65 verwendet. Für eine Zuführung unterschiedlicher Prozessgaszusammensetzungen wird ein Primärprozessgasventil 66 sowie ein Sekundärprozessgasventil 67 verwendet. Denkbar ist auch das Zuführen weiterer Prozessgasmischungen, sodass weitere Leitungen und weitere Ventile hinzutreten könnten. Die Bereitstellung der Prozessgasmischungen erfolgt durch eine Gasversorgungsvorrichtung.

Ein typischer Behandlungsvorgang wird z.B. derart durchgeführt, daß zunächst der Behälter 5 wie zu Figur 1 erläutert zum Plasmarad 2 transportiert wird und das Einsetzen des Behälters 5 in die Plasmastation 1 in einem hochgeschobenen Zustand der hülsenartigen Kammerwandung 18 erfolgt. Nach einem Abschluss des Einsetzvorganges wird die Kammerwandung 18 in ihre abgedichtete Positionierung abgesenkt und zunächst gleichzeitig eine Evakuierung sowohl der Kavität 17 als auch eines Innenraumes des Behälters 5 durchgeführt, ggf. erfolgt zunächst auch nur eine Vorevakuierung der Kavität 17, bevor auch die Evakuierung des Innenraums des Behälters 5 zugeschaltet wird.

Nach einer ausreichenden Evakuierung des Innenraumes der Kavität 17 wird die Lanze 36 in den Innenraum des Behälters 5 eingefahren und eine Abschottung des Innenraumes des Behälters 5 gegenüber dem Innenraum der Kavität 17 durchgeführt. Ebenfalls ist es möglich, die Lanze 36 bereits synchron zur beginnenden Evakuierung des Innenraumes der Kavität 17 in den Behälter 5 hineinzuverfahren. Der Druck im Innenraum des Behälters 5 wird anschließend noch weiter abgesenkt. Darüber hinaus ist auch daran gedacht, die Positionierbewegung der Lanze 36 wenigstens teilweise bereits parallel zur Positionierung der Kammerwandung 18 durchzuführen. Nach Erreichen eines ausreichend tiefen Unterdruckes wird Prozessgas in den Innenraum des Behälters 5 eingeleitet und mit Hilfe des Mikrowellengenerators 19 das Plasma gezündet. Insbesondere ist daran gedacht, mit Hilfe des Plasmas sowohl einen Haftvermittler auf eine innere Oberfläche des Behälters 5 als auch die eigentliche Barriereschicht aus Siliziumoxiden abzuscheiden. Eine zusätzliche dritte Schicht, zum Beispiel eine Schutzschicht, könnte ebenfalls mit Hilfe des Plasmas abgeschieden werden, z.B. ebenfalls aus Siliziumoxiden.

Nach einem Abschluss des Beschichtungsvorganges wird die Lanze 36 wieder aus dem Innenraum des Behälters 5 entfernt und die Plasmakammer 17 sowie der Innenraum des Behälters 5 werden belüftet. Nach Erreichen des Umgebungsdruckes innerhalb der Kavität 17 wird die Kammerwandung 18 wieder angehoben, um eine Entnahme des beschichteten Behälters 5 sowie eine Eingabe eines neuen zu beschichtenden Behälters 5 durchzuführen. Das geschilderte Beschichtungsverfahren läuft ab, während der Behälter 5 in der Plasmastation 1 auf dem Plasmarad 2 umläuft.

Eine Positionierung der Kammerwandung 18 und/oder der Lanze 36 kann unter Verwendung unterschiedlicher Antriebsaggregate erfolgen. Grundsätzlich ist die Verwendung pneumatischer Antriebe und/oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades 2 eine Kurvensteuerung zu realisieren. Die Kurvensteuerung kann beispielsweise derart ausgeführt sein, daß entlang eines Umfanges des Plasmarades 2 Steuerkurven angeordnet sind, entlang derer Kurvenrollen geführt werden. Die Kurvenrollen sind mit den jeweils zu positionierenden Bauelementen gekoppelt.

Die Betätigung der Ventile 59 erfolgt vorzugsweise über eine programmierbare elektronische Steuerung. Zunächst wird nach einem Schließen der Plasmakammer 17 das Primärvakuumventil 60 geöffnet und der Innenraum des Behälters 5 und der Innenraum der Plasmakammer 17 gleichzeitig oder teilweise zeitlich versetzt evakuiert. Hierbei wird ein Druckniveau z.B. im Bereich von 20 mbar bis 50 mbar erreicht. Nach einem Schließen des Primärvakuumventils 60 erfolgt ein Öffnen des Sekundärvakuumventils 61 und der Innenraum des Behälters 5 und der Innenraum der Plasmakammer 17 werden zunächst gleichzeitig an eine Unterdruckquelle mit einem niedrigeren Druckniveau angeschlossen. Nach einer ausreichenden Evakuierung des den Behälter 5 umgebenden Innenraumes der Plasmakammer 17 schließt das Kammervakuumventil 63 und lediglich der Innenraum des Werkstückes 5 wird weiter evakuiert. Hierbei wird z.B. ein Druckniveau von etwa 0,1 mbar erreicht.

Nach einem Schließen des Kammervakuumventils 63 und einer in der Regel bereits zuvor erfolgten Positionierung der Lanze 36 innerhalb des Innenraumes des Behälters 5 öffnet das Primärprozessgasventil 66 und ein Prozessgas einer ersten Zusammensetzung wird zugeführt. Nach einer ausreichenden Prozessgaszuführung zündet der Mikrowellengenerator 19 das Plasma im Innenraum des Behälters 5. Zu einem vorgebbaren Zeitpunkt schließt das Primärprozessgasventil 66 und das Sekundärprozessgasventil 67 öffnet zur Zuführung eines Prozessgases einer zweiten Zusammensetzung. Zumindest zeitweise parallel zum Öffnen der Prozessgasventile 66, 67 öffnet auch das Prozessvakuumventil 62, um einen ausreichend niedrigen Unterdruck im Innenraum des Behälters 5 aufrecht zu erhalten. Hierbei erweist sich ein Druckniveau von z.B. etwa 0,3 mbar als zweckmäßig

Nach einem Abschluss der Plasmabeschichtung öffnet zunächst das Behälterentlüftungsventil 64 und schließt den Innenraum des Behälters 5 an einen Umgebungsdruck an. Mit einer vorgebbaren zeitlichen Verzögerung nach einem Öffnen des Behälterentlüftungsventils 64 öffnet auch das Kammerentlüftungsventil 65, um den Innenraum der Plasmakammer 17 wieder vollständig auf den Umgebungsdruck anzuheben. Nach einem zumindest annäherungsweisen Erreichen des Umgebungsdruckes innerhalb der Plasmakammer 17 kann die Plasmakammer 17 öffnen und der beschichtete Behälter 5 wird entnommen und durch einen neuen zu beschichtenden Behälter 5 ersetzt.

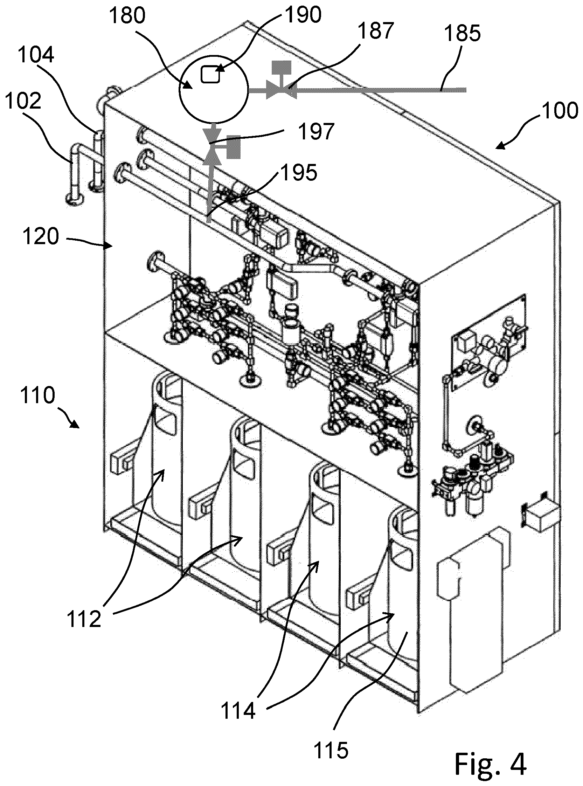

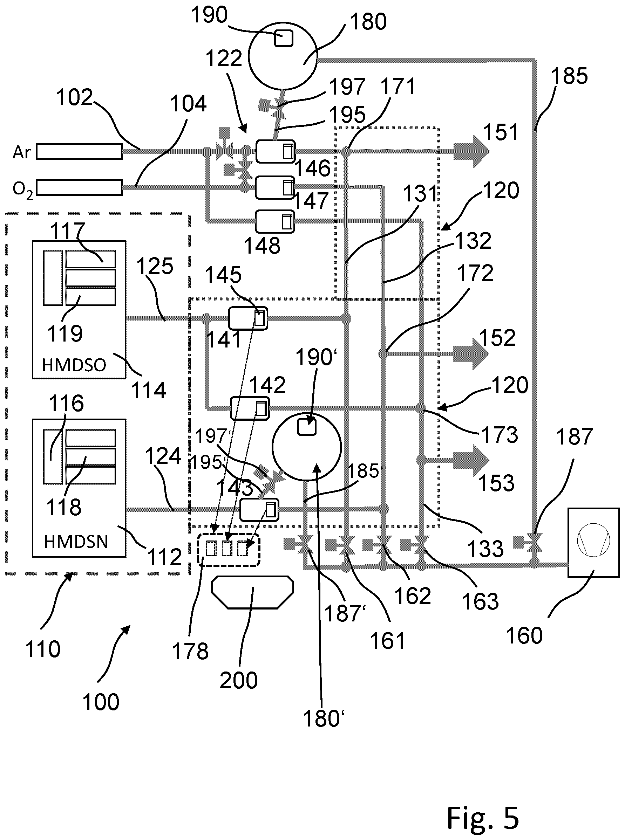

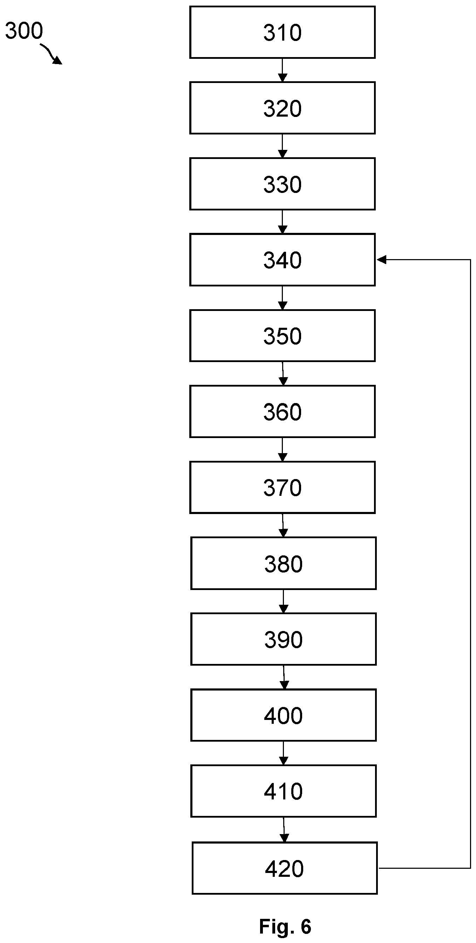

Die Bereitstellung der Prozessgase für eine beispielhaft wie oben beschriebene Beschichtungsanlage und für beispielhaft wie oben beschrieben ablaufende Beschichtungsprozesse übernimmt eine nachfolgend zu beschreibende erfindungsgemäße Gasversorgungsvorrichtung 100. Figur 4 zeigt ein beispielhaftes Aussehen und einen beispielhaften Aufbau einer solchen Gasversorgungsvorrichtung 100. Figur 5 zeigt in einer Prinzipskizze, welche Vorgänge in einer solchen Gasversorgungsvorrichtung 100 ablaufen und wie eine Anordnung hierfür eingesetzter Leitungen und Dosiereinrichtungen mit Vorteil erfolgt. Figur 6 zeigt eine Prinzipdarstellung zu einem erfindungsgemäßen Verfahrensablauf einer Druckanstiegsmessung, die in einer erfindungsgemäß ausgeführten Gasversorgungsvorrichtung ausgeführt werden kann.

Die in Figur 4 dargestellte Gasversorgungsvorrichtung 100 ist ausgeführt in Form eines Schrankes mit Seiten- und Rückwänden und mit Schranktüren im Frontbereich, die nicht gezeigt sind, um einen Blick ins Vorrichtungsinnere zu erlauben. Diese Wände begrenzen also Kammern bzw. Teilkammern der Gasversorgungsvorrichtung 100. In diesen Kammern verlaufen Leitungen und sind Einrichtungen der Gasversorgungsvorrichtung angeordnet, z.B. Einrichtungen, um Grundgase zu führen, um das Strömen der Gase mittels Ventilen zu beherrschen, um Grundgase mittels MFC zu dosieren, um Grundgase in Mischeinrichtungen miteinander zu mischen und/oder um Grundgase in Verdampfern aus PrecursorFlüssigkeiten zu erzeugen.

Der Gasversorgungsschrank 100 ist im dargestellten Beispiel in vertikaler Richtung unterteilt in einen unteren Schrankbereich 110 und einen oberen Schrankbereich 120. Im unteren Schrankbereich 110 sind im dargestellten Ausführungsbeispiel vier mit einer PrecursorFlüssigkeit gefüllte Fässer 112, 114 angeordnet, welche im gezeigten Beispiel durch Vertikalwände voneinander getrennt sind. Die beiden auf der linken Seite der Darstellung gezeigten Fässer 112 sollen z.B. HMDSN enthalten, und die beiden auf der rechten Seite der Darstellung gezeigten Fässer 114 sollen z.B. HMDSO enthalten. Alle Fässer sind in der gleichen Weise jeweils von einer Heizmanschette 115 umgeben und eine Temperatursteuerung 116 regelt die Heizleistung der jeweiligen Heizmanschetten 115 so, dass das in den Fässern 112, 114 aufgenommene Precursorfluid in den gasförmigen Zustand überführt wird. Die Fässer bilden zusammen mit den Heizmanschetten Verdampfer. Es gelten die Ausführungen in der allgemeinen Beschreibung über vorteilhafte Temperaturen, die von diesen Manschetten 115 zusammen mit der Temperatursteuerung 116 eingestellt werden.

In dem Schrankbereich 120 vertikal oberhalb des Schrankbereiches 110 mit den Fässern 112, 114 sind diverse Leitungen, Armaturen, Ventile und Dosiermittel angeordnet, um die durch Verdampfen der Precursor bereitgestellten Grundgase zu leiten, zu dosieren und zu mischen, z.B. mit weiteren Grundgasen, die über Zuführleitungen 102, 104 seitlich links von der Gasversorgungsvorrichtung 100 in die obere Teilkammer 120 hineingeführt werden. Bei diesen schon gasförmig vorliegenden weiteren Grundgasen handelt es sich z.B. um Sauerstoff und Argon. Aus diesen bereits gasförmig der Gasversorgungsvorrichtung 100 zugeführten Grundgasen Sauerstoff und Argon sowie aus den durch Verdampfen von HMDSN und HMDSO entstehenden Grundgasen lassen sich Gasmischungen bereitstellen, um in der zuvor beschriebenen Beschichtungsanlage 10 auf der Innenwand eines Behälters 5 zeitlich nacheinander mehrere Schichten abzuscheiden, z.B. zunächst eine Haftvermittlerschicht, dann eine Barriereschicht und schließlich eine Schutzschicht. Andere Schichtaufbauten und andere Anzahlen von Schichten sind möglich.

Die Teilkammer 120 mit den Leitungen, Armaturen, Ventilen und Dosiermitteln kann z.B. insgesamt als Warmbereich bzw. Warmkammer ausgeführt sein, so wie in der allgemeinen Beschreibung erläutert. Bevorzugt werden aber bestimmte Elemente außerhalb eines solchen Warmbereiches angeordnet, wie dies später anhand der Prinzipskizze in Figur 5 verdeutlicht werden soll.

Die Ausbildung als Warmbereich kann z.B. derart ausgeführt sein, dass eine Heizeinrichtung eine bestimmte Temperatur in dem Warmbereich einstellt und z.B. ein Temperaturfühler laufend die Temperatur im Warmbereich erfasst. Heizeinrichtung und Temperaturfühler können z.B. in einen Regelkreis oder in einen Steuerkreis integriert sein, um die Temperatur im Warmbereich konstant auf einer gewünschten Temperatur zu halten. Diese Temperatur kann wie im allgemeinen Beschreibungsteil angegeben ausgewählt sein und z.B. 5 °C oberhalb der Temperatur liegen, die die Heizmanschetten in den Fässern 112 bzw. 114 einstellen, mindestens aber auf oder oberhalb der Siedetemperatur der in den Fässern aufgenommenen Flüssigkeiten, um eine Kondensation der erzeugten Gase zu vermeiden. Die Temperatur im Warmbereich kann insofern als kondensationsvermeidende Temperatur bezeichnet werden.

Erfindungsgemäß weist die Gasversorgungsvorrichtung 100 eine Referenzeinrichtung 180 auf, die im dargestellten Fall außerhalb des Warmbereiches 120 angeordnet ist. Weiter gezeigt ist, dass ein Drucksensor 190 vorgesehen ist, welcher den Druck innerhalb der Referenzeinrichtung 180 zu erfassen gestattet. Eine nicht dargestellte Vakuumpumpe ist über eine Pumpleitung 185, beherrscht von einem Ventil 187, mit der Referenzeinrichtung 180 verbindbar. Ebenso ist die Referenzeinrichtung 180 über eine weitere Leitung, die Referenzleitung 195, welche von einem weiteren Ventil 197 beherrscht wird, mit der Grundgasleitung 102 verbindbar, über die aus einem nicht dargestellten Gasreservoir ein Grundgas zugeführt wird, z.B. Argon. Bei den genannten Ventilen 187 und 197 handelt es sich jeweils um schaltbare Ventile, welche z.B. von einer nicht gezeigten Steuereinrichtung in eine Offenstellung oder in eine Geschlossenstellung gebracht werden können. Diese erfindungsgemäße Referenzeinrichtung 180 kann z.B. im normalen Produktionsbetrieb der Anlage 10 und somit im normalen Bereitstellungsbetrieb der Gasversorgungsvorrichtung100 inaktiv sein, indem beide Ventile 187 und 197 geschlossen bleiben.

Die Referenzeinrichtung 180 besteht im Wesentlichen aus einem Innenvolumen bekannter Größe, ist also als Hohlkörper ausgebildet, und diese Referenzeinrichtung 180 wird benötigt für das Ausführen einer Druckanstiegsmessung, die in grundsätzlicher Art in der allgemeinen Beschreibung in einer Ausführungsform beschrieben worden ist. Zu Figur 6 wird später eine mögliche Druckanstiegsmessung weiter erläutert.

In nicht in Figur 4 dargestellter Weise könnte innerhalb des Warmbereiches 120 eine weitere Referenzeinrichtung angeordnet sein und z.B. mit einer Grundgasleitung verbindbar sein, welche ein durch Verdampfen aus HMDSN oder HMDSO entstandenes Grundgas führt. Die Figur 5 wird prinzipienhaft dazu ein Beispiel zeigen.

Figur 5 zeigt in Übereinstimmung mit dem Beispiel in Figur 4, dass über Zuführleitungen 102, 104 die Grundgase Argon und Sauerstoff in gasförmiger Form der Gasversorgungsvorrichtung 100 zugeführt werden. Diese Grundgase dienen z.B. als Trägergase, Sauerstoff nimmt aber auch am Abscheideprozess teil. Die flüssigen Precursor HMDSO und HMDSN sind in jeweiligen Vorratsbehältern 112, 114 aufgenommen. Diese Vorratsbehälter 112, 114 sind ausgestattet z.B. mit einem Temperatursensor 117 und/oder einem Drucksensor 118 und/oder einem Füllstandssensor 119. Weiterhin sind diese Vorratsbehälter 112, 114 mit einer Steuerungseinrichtung 116 verbunden, um die im Behälter 112, 114 enthaltene Flüssigkeit auf eine gewünschte Temperatur zu erhitzen. Diese Steuerungseinrichtung kann z.B. die zentrale Steuerung der Anlage (10) sein. Beide genannten Beispiele für eine Precursorflüssigkeit weisen eine Siedetemperatur von 45 °C auf und die Erwärmung erfolgt bis mindestens auf diese Siedetemperatur, bevorzugt auf eine Temperatur oberhalb dieser Siedetemperatur. Es wird zu vorteilhaften Temperaturen auf die allgemeine Beschreibung verwiesen.

Aus Gründen der Übersichtlichkeit sind in Figur 5 nur wenige schaltbare Ventile 122 dargestellt. Es versteht sich, dass weitere Ventile 122 vorgesehen sein können, um den Gasstrom in den diversen Gasleitungen zu beherrschen.

Die genannten Vorratsbehälter 112, 114 mit HMDSO und HMDSN sind wie in Figur 4 dargestellt in einem ersten Schrankbereich 110 angeordnet. Von den Vorratsbehälter 112, 114 führen Grundgasleitungen 124, 125 bis in einen davon räumlich und baulich getrennten zweiten Schrankbereich 120, der als Warmbereich 120 bzw. als Warmkammer 120 ausgebildet ist, wie in der allgemeinen Beschreibung erläutert. Die räumliche und bauliche Trennung ist aber nicht zwingend vorzusehen. Die in diesem Warmbereich 120 verlaufenden Leitungen 124, 125, 131, 132, 133 und die in diesem Bereich angeordneten Dosiermittel 141, 142, 143, wie z.B. MFC`s, sollen auf einer Temperatur gehalten sein, die oberhalb der Siedetemperatur der in den Vorratsbehältern 112, 114 aufgenommenen Precursorflüssigkeiten liegen bzw. oberhalb der Temperaturen liegen sollen, auf denen die Precursorflüssigkeiten in den Vorratsbehältern 112, 114 gebracht werden. Bevorzugt soll ein zusätzlicher Temperaturunterschied von 5 °C eingestellt sein, d. h. der Warmbereich 120 soll auf eine um 5 °C höhere Temperatur gehalten sein, als die Siedetemperatur bzw. die Aufheiztemperatur.

Im rechten Bereich der Figur 5 ist angedeutet, dass drei Prozessgasmischungen 151, 152, 153 bereitgestellt werden sollen, wobei diese Prozessgasmischungen in nicht dargestellter Weise einer Beschichtungsanlage 10 zugeführt werden, z.B. über in Figur 3 dargestellte Leitungen mit den Ventilen 66 und 67, wobei für die dritte Prozessgasmischung eine weitere Leitung mit einem weiteren Ventil hinzutreten könnte. Weiterhin ist in Figur 5 eine Vakuumpumpe 160 dargestellt, die über jeweilige Schaltmittel, z.B. Magnetventile 161, 162, 163, Vakuum auf die Leitungen 131, 132, 133 geben kann, in denen die drei genannten Prozessgasmischungen 151 152, 153 aus der Gasversorgungsvorrichtung 100 herausgeführt werden. Auf diese Weise kann ein Bypassweg bereitgestellt werden, um nicht von der Beschichtungsvorrichtung 10 abgenommene Gasmengen abzusaugen, z.B. in den Phasen, in denen ein Behälterwechsel erfolgt, oder in den Phasen, in denen andere Prozessgasmischungen abgenommen werden.

Die der Gasversorgungsvorrichtung 100 in gasförmiger Form zugeführten Grundgase (Argon, Sauerstoff) werden von diesen zugeordneten Dosiermitteln, beispielsweise MFC's 146, 147, 148, dosiert Mischbereichen 171, 172, 173 zugeführt. Im dargestellten Beispiel sind die MFC 146, 147, 148 diesen Grundgasen zugeordnet. Diese MFC 146, 147, 148 sind außerhalb des Warmbereiches 120 angeordnet, da diese MFC 146, 147, 148 nicht auf erhöhter Temperatur gehalten werden müssen, denn ein Kondensieren des geführten Gases kann nicht eintreten, denn die dort strömenden Gase liegen bei den üblichen Raumtemperaturen in Gasform vor. Die MFC 141, 142, 143, welche der Dosierung der Grundgase dienen, die nach Verdampfen aus den Precursorflüssigkeiten entstehen, sind hingegen im Warmbereich 120 angeordnet. Dies erfolgt, um ein Kondensieren dieser Grundgase in den Leitungen 131, 132, 133 und/oder in den Dosiermitteln 141, 142, 143 zu verhindern.

Jedes der dargestellten MFC 141, 142, 143, 146, 147, 148 ist jeweils ausgestattet mit einer jeweiligen Steuerelektronik 145. Die jeweiligen Steuerelektroniken 145 der MFC 141, 142, 143 sind optional und mit Vorteil beabstandet von den davon gesteuerten MFC 141, 142, 143 angeordnet, siehe Anordnung im gestrichelte Bereich 178, und die Anordnung dieser beabstandet von den MFC 141, 142, 143 vorgesehenen Steuerelektroniken 145 erfolgt außerhalb des Warmbereiches 120. Zwar ist zu den MFC 146, 147, 148 dargestellt, dass deren Steuerelektronik 145 jeweils unmittelbar bei den MFC 146, 147, 148 verbleiben.

Denkbar ist aber auch, dass auch diese Steuerelektroniken 145 beanstandet von den MFC 146, 147, 148 angeordnet werden und z.B. gemeinsam mit den anderen Steuerelektroniken 145 im Bereich 178 angeordnet werden, um dort eine Steuereinheit 178 mit allen Steuerelektroniken 145 der MFC 141, 142, 143, 146, 147, 148 auszubilden. Diese Steuereinheit 178 könnte z.B. klimatisiert ausgeführt sein und/oder in räumlicher Nähe zu der Steuereinrichtung 200 der Gasversorgungsvorrichtung 100 oder zu einer Steuereinrichtung der Beschichtungsanlage 10 angeordnet werden.

Wie weiterhin aus Figur 5 erkennbar, führen die Grundgasleitungen 102, 104 der Trägergase stromabwärts der MFC 146, 147, 148 in den Warmbereich hinein bis hin zu Mischbereichen 171, 172, 173, die als Kreuzungspunkte ausgeführt sind, in denen unterschiedliche Grundgase führende Grundgasleitungen zusammenlaufen. An diesem Kreuzungspunkten 171, 172, 173 werden Grundgase zusammengeführt, die einerseits bereits in gasförmiger Form vorlagen (Argon, Sauerstoff) und die andererseits durch Verdampfen von Precursorflüssigkeiten erzeugt wurden. Aus diesem Grunde ist das Anordnen dieser Mischbereiche 171, 172, 173 bzw. der Kreuzungspunkte im Warmbereich 120 vorteilhaft, um auch in diesen Mischbereichen 171, 172, 173 und den in Strömungsrichtung nachfolgenden Leitungen ein Kondensieren zu vermeiden.

Figur 5 zeigt also beispielhafte verallgemeinerbare Aspekte, nämlich einerseits, dass ein Teil der Dosiermittel bzw. MFC innerhalb des Warmbereiches angeordnet ist und ein anderer Teil außerhalb des Warmbereichs. Bevorzugt und wie in Figur 5 dargestellt soll unterschieden werden zwischen den Dosiermitteln, die aus flüssigen Precursor erzeugten Grundgasen zugeordnet sind, welche nämlich im Warmbereich angeordnet werden, und den MFC, die Grundgasleitungen zugeordnet sind, in denen bereits gasförmig zugeführte Grundgase geführt sind, welche nämlich außerhalb des Warmbereiches angeordnet sind. Weiterhin sollen nach einem weiteren Aspekt die Steuerelektroniken der im Warmbereich aufgenommenen MFC beanstandet von den MFC außerhalb des Warmbereiches angeordnet sein. Als weiterer Aspekt kann der Figur 5 entnommen werden, dass nur diejenigen Leitungen und Dosiermittel innerhalb des Warmbereiches angeordnet sind, in denen aus flüssigen Precursern entstandene Grundgase geführt werden, während Leitungen und Dosiermittel außerhalb des Warmbereiches angeordnet werden können und in Figur 5 auch angeordnet sind, welche ausschließlich Grundgase führen, die bereits gasförmig vorliegen. Auf diese Weise kann der Warmbereich geringer dimensioniert ausgeführt werden und die MFC können übliche MFC sein, die bei üblicher Raumtemperatur zufriedenstellend arbeiten.

Figur 5 zeigt wie auch Figur 4 oberhalb des Warmbereiches 120 eine Referenzeinrichtung 180, die mit einem Drucksensor 190 ausgestattet ist. Auch die schon in Figur 4 gezeigte Pumpleitung 185 ist in Figur 5 erkennbar, es besteht Anbindung über das Ventil 187 an die Vakuumpumpe 160. Die Referenzeinrichtung 180 ist zudem über Ventil 197 an MFC 146 angeschlossen, nämlich über Referenzleitung 195.

Zusätzlich und wie bereits zu Figur 4 angedeutet, ist eine weitere Referenzeinrichtung 180' innerhalb des Warmbereichs 120 angeordnet. Auch diese Referenzeinrichtung 180' steht über eine Pumpleitung 185` mit Vakuumpumpe 160 in Verbindung, diese Verbindung wird beherrscht von einem Ventil 187'. Die Referenzeinrichtung 180' ist über Referenzleitung 195` anschließbar an MFC 143. Dieser Anschluss ist ventilbeherrscht von Ventil 197'.

In nicht dargestellter Weise könnte diese Referenzeinrichtung 180 und könnte die Referenzeinrichtung 180` noch an weitere Grundgasleitungen angeschlossen werden, jeweils verwirklicht z.B. durch eigenständige Referenzleitungen mit eigenständigen Ventilen. Alternativ könnten weitere nicht gezeigte Referenzeinrichtungen vorgesehen sein, wie dies in der allgemeinen Beschreibung angegeben ist, z.B. um jeder Grundgasleitung eine eigenständige Referenzeinrichtung zuzuweisen oder z.B. um MFC mit vergleichbarer Durchflussrate ein gemeinsames Referenzvolumen zuordnen zu können, das für diese Durchflussrate besonders geeignete Messbedingungen für einen Druckanstiegstest schafft.

Figur 6 zeigt in einer Prinzipdarstellung einen Verfahrensablauf einer Druckanstiegsmessung 300 unter Verwendung z.B. einer der in den Figuren 4 und 5 gezeigten Referenzeinrichtungen 180, 180'. In einer solchen Druckanstiegsmessung 300 pumpt z.B. in einem ersten Schritt 310 zunächst die Vakuumpumpe 160 über die Pumpleitung 185 das von der Referenzeinrichtung 180 bereitgestellte Volumen ab bis zum Erreichen eines Unterdruckes, der z.B. vorgegeben sein kann, oder der z.B. innerhalb einer vorgegebenen Abpumpdauer erreicht wird. Bezugszeichen 320 stellt das Erreichen dieser Druck- oder Zeitgrenze dar. Danach wird z.B. in Schritt 330 das Ventil 187 geschlossen. Optional wird in Schritt 340 eine Leckrate ermittelt, das heißt es wird der Druckverlauf über die Zeit erfasst, ohne dass eines der Ventile in den zu der Referenzeinrichtung führenden Leitungen geöffnet ist. Im Anschluss kann dann optional und falls notwendig in Schritt 350 erneut ein Abpumpen erfolgen. Es kann dann Ventil 197 in Schritt 360 geöffnet werden, damit über das z.B. in Figur 5 dargestellte MFC 143 ein Grundgas von dem MFC 143 in dosierter Form in das Volumen der Referenzeinrichtung 180 hineinströmen kann. Der Drucksensor 190 erfasst in Stufe 370 über die Zeit hinweg den Druck innerhalb der Referenzeinrichtung 180. In Stufe 380 wird aus dem zeitlichen Verlauf des Druckes die pro Zeiteinheit in die Referenzeinrichtung 180 hineinströmende Gasmenge ermittelt, ggf. unter Berücksichtigung der zuvor ermittelten Leckrate. Es kann z.B. in Stufe 390 ausgewertet werden, ob diese experimentell ermittelte Gasmenge der Gasmenge entspricht, die das MFC 143 pro Zeit zudosieren soll. In den weiteren Stufen 400-420 kann z.B. ein anderes MFC analog wie vorstehend beschrieben eine Gasmenge in die Referenzeinrichtung 180 zudosieren und ebenfalls geprüft werden, ob die experimentell ermittelte Gasmenge pro Zeiteinheit, der Gasmenge entspricht, die von diesem zweiten MFC pro Zeit zudosiert werden soll. Der eine Rückmeldung andeutende Pfeil zwischen Stufe 420 und Stufe 340 soll zeigen, dass bei Feststellen einer Abweichung z.B. eine Rückmeldung an das getestete MFC gegeben werden kann, zu dem eine Abweichung festgestellt wurde, um den Öffnungsgrad dieses MFC zu verändern in Richtung auf eine Verringerung der Abweichung. Wenn also die Abweichung darin besteht, dass das MFC eine zu geringe Gasmenge pro Zeiteinheit zudosiert, wäre die Durchlassöffnung des MFC zu vergrößern. Soweit dies nicht durch eine Steuerungseinrichtung bewirkt werden kann, könnte eine Bedienperson, z.B. durch eine entsprechende Anzeige, auf die Notwendigkeit hingewiesen werden, an dem MFC die Einstellung zu verändern oder das MFC gegen ein anderes MFC auszutauschen.

## Patentansprüche

1. Vorrichtung (100) zur Versorgung einer Anlage (10) zur Beschichtung von Werkstücken (5) mit benötigten Prozessgasen für den auf der Anlage (10) ablaufenden Beschichtungsprozess, insbesondere zur Beschichtung von Innenwänden von Behältern (5), insbesondere mittels eines PECVD-Verfahrens, insbesondere mittels eines mikrowelleninduzierten PECVD-Verfahrens,
wobei die Vorrichtung (100) wenigstens zwei Grundgasleitungen (124, 125; 102, 104) zum getrennten Führen von wenigstens zwei Grundgasen in einer Strömungsrichtung und wenigstens ein Mischmittel (171, 172, 173) zum Zusammenführen und Mischen von wenigstens zwei der Grundgase zu einem Gasgemisch aufweist,
wobei zur dosierten Zuführung der Grundgase zum Mischmittel (171, 172, 173) in den Grundgasleitungen (102, 104; 124, 125) in der Strömungsrichtung der zugeführten Grundgase vor dem Mischmittel (171, 172, 173) jeweils ein Massflow-Controller (MFC; 141, 142, 143; 146, 147, 148) angeordnet ist,
wobei die Vorrichtung (100) zur Bereitstellung eines ersten Grundgases wenigstens einen Verdampfer (112, 114) aufweist, der eingerichtet und ausgebildet ist zur Überführung eines flüssigen Ausgangsfluides in den gasförmigen Zustand, wobei der Verdampfer (112, 114) hierzu insbesondere Heizmittel (115) zum Erwärmen des Ausgangsfluides mindestens bis zu dessen Siedetemperatur aufweist,
wobei wenigstens der MFC (141, 142, 143), der das aus einem flüssigen Ausgangsfluid entstandene Grundgas dosiert zum Mischmittel (171, 172, 173) führt, auf einer kondensationsvermeidenden Temperatur größer oder gleich der Siedetemperatur gehalten ist,
**dadurch gekennzeichnet, dass**
die Vorrichtung (100) eine Referenzeinrichtung (180, 180') aufweist, die ein Referenzvolumen bekannter Größe bereitstellt und die ebenfalls auf einer kondensationsvermeidenden Temperatur größer oder gleich der Siedetemperatur gehalten ist, wobei die Referenzeinrichtung (180, 180') einen Drucksensor (190, 190') zum Erfassen des Druckes in dem Referenzvolumen aufweist, wobei das Referenzvolumen über eine von einem schaltbaren Ventil (187, 187') beherrschte Pumpleitung (185, 185') an eine Pumpeinrichtung (160) zur Erzeugung eines Unterdrucks in dem Referenzvolumen angeschlossen ist, und wobei der auf der kondensationsvermeidenden Temperatur gehaltene MFC (141, 142, 143) über eine von einem schaltbaren Ventil (197, 197`) beherrschte Referenzleitung (195, 195`) an das Referenzvolumen angeschlossen ist.

2. Vorrichtung (100) nach Anspruch 1, **dadurch gekennzeichnet, dass** die Vorrichtung (100) zur Bereitstellung von zwei oder mehr Grundgasen zwei oder mehr Verdampfer (112, 114) aufweist, die jeweils eingerichtet und ausgebildet sind zur Überführung eines flüssigen Ausgangsfluides in den gasförmigen Zustand, wobei die jeweiligen Verdampfer (112, 114) hierzu insbesondere Heizmittel (115) zum Erwärmen des jeweiligen Ausgangsfluides mindestens bis zur jeweiligen Siedetemperatur aufweist, wobei diesen aus flüssigen Ausgangsfluiden entstandenen Grundgasen jeweils wenigstens ein MFC (141, 142, 143) zugeordnet ist, der jeweils an eine Referenzeinrichtung (180, 180`) mit den Eigenschaften des Kennzeichens von Anspruch 1 angeschlossen ist, wobei bevorzugt alle jeweiligen MFC an der gleichen Referenzeinrichtung angeschlossen sind.

3. Vorrichtung (100) nach Anspruch 1 oder 2, **dadurch gekennzeichnet, dass** die Vorrichtung einen von Wänden umgebenen Warmbereich (120) aufweist, der auf einer kondensationsvermeidenden Temperatur größer oder gleich der Siedetemperatur gehalten ist, wobei der MFC oder wobei die MFC (141, 142, 143) dadurch auf die kondensationsvermeidende Temperatur gehalten ist bzw. sind, indem der MFC oder indem die MFC (141, 142, 143) innerhalb dieses Warmbereiches (120) angeordnet ist bzw. sind, und/oder wobei die Referenzeinrichtung (180`) in dem Wärmebereich (120) angeordnet und dadurch auf einer kondensationsvermeidenden Temperatur gehalten ist.

4. Vorrichtung (100) nach einem der vorhergehenden Ansprüche, **dadurch gekennzeichnet, dass** die Vorrichtung (100) zur Bereitstellung eines weiteren Grundgases angeschlossen ist an eine Zuführleitung (102, 104) für das Zuführen des zweiten Grundgases aus einer Gasquelle, wobei wenigstens ein diesem aus einer Gasquelle entstandenen Grundgas zugeordneter MFC (146, 147, 148) an eine Referenzeinrichtung (180) mit den Eigenschaften des Kennzeichens von Anspruch 1 angeschlossen ist, wobei dieser MFC (146, 147, 148) bevorzugt außerhalb des Warmbereiches (120) angeordnet ist, wobei weiter bevorzugt die zugeordnete Referenzeinrichtung (180) ebenfalls außerhalb des Warmbereichs (120) angeordnet ist und bevorzugt ein anderes Referenzvolumen aufweist, als die im Warmbereich (120) angeordnete Referenzeinrichtung (180`).

5. Vorrichtung (100) nach einem der Ansprüche 3 oder 4, **dadurch gekennzeichnet, dass** die MFC (141, 142, 143; 146, 147, 148) jeweils eine Steuerelektronik (145) aufweisen, und die Steuerelektronik (145) wenigstens eines im Warmbereich (120) angeordneten MFC's (141, 142, 143) außerhalb des Warmbereiches (120) angeordnet ist, bevorzugt sind die Steuerelektroniken (145) aller im Warmbereich (120) angeordneten MFC (141, 142, 143) außerhalb des Warmbereiches (120) angeordnet.

6. Vorrichtung (100) nach einem der vorhergehenden Ansprüche 4 und 5 und soweit auf Anspruch 3 rückbezogen, **dadurch gekennzeichnet, dass** alle MFC (146, 147, 148) in den Grundgasleitungen (102, 104), in denen Grundgase aus einer Gasquelle geführt sind, außerhalb des Warmbereiches (120) angeordnet sind.

7. Vorrichtung (100) nach einem der vorhergehenden Ansprüche 3 bis 6 und soweit auf Anspruch 3 rückbezogen, **dadurch gekennzeichnet, dass** die kondensationsvermeidende Temperatur im Warmbereich (120) wenigstens 5 °C über der Siedetemperatur gehalten ist.

8. Vorrichtung (100) nach einem der vorhergehenden Ansprüche, insbesondere soweit auf Anspruch 3 rückbezogen, **dadurch gekennzeichnet, dass** der Verdampfer (114, 112) oder jeder der Verdampfer (114, 112) ausgebildet ist, das Ausgangsfluid mindestens auf 10 °C, bevorzugt mindestens 15 °C und weiter bevorzugt mindestens 20 °C oberhalb dessen Siedetemperatur aufzuheizen, wobei die kondensationsvermeidende Temperatur im Warmbereich (120) bevorzugt wenigstens 5 °C oberhalb dieser Aufheiztemperatur gehalten ist.

9. Anlage (10) zur Beschichtung von Werkstücken (5), insbesondere zur Beschichtung von Innenwänden von Behältern (5), insbesondere mittels eines PECVD-Verfahrens, insbesondere mittels eines mikrowelleninduzierten PECVD-Verfahrens, mit einer Vorrichtung (100) zur Bereitstellung der für den Beschichtungsprozess benötigten Prozessgase, wobei diese Vorrichtung (100) nach einem der vorhergehenden Ansprüche ausgebildet ist.

10. Verfahren zum Betreiben einer Vorrichtung (100) zur Versorgung einer Anlage (10) zur Beschichtung von Werkstücken (5) mit für den Beschichtungsprozess benötigten Prozessgasen, insbesondere zur Beschichtung von Innenwänden von Behältern (5), insbesondere mittels eines PECVD-Verfahrens, insbesondere mittels eines mikrowelleninduzierten PECVD-Verfahrens,
wobei wenigstens zwei Grundgase in wenigstens zwei Grundgasleitungen (102, 104; 124, 125) geführt werden bis zu wenigstens einem Mischpunkt (171, 172, 173) und dort zu einem Gasgemisch zusammengeführt werden,
wobei das Zuführen zu dem wenigstens einen Mischpunkt (171, 172, 173) dosiert erfolgt, indem Massflow-Controller (MFC; 141, 142, 143; 146, 147, 148) in den Grundgasleitungen (102, 104; 124, 125) angeordnet werden,
wobei ein erstes Grundgas erzeugt wird durch Überführen eines flüssigen Ausgangsfluides in den gasförmigen Zustand, nämlich durch Erhitzen auf eine Temperatur oberhalb dessen Siedetemperatur,
wobei das Zuführen des ersten Grundgases durch wenigstens ein MFC (141, 142, 143) erfolgt, welcher auf einer kondensationsvermeidenden Temperatur größer oder gleich der Siedetemperatur gehalten wird,
**dadurch gekennzeichnet, dass**
in der Vorrichtung (100) eine Referenzeinrichtung (180, 180`) bereitgestellt wird, die ein Referenzvolumen bekannter Größe bereitstellt und die auf einer kondensationsvermeidenden Temperatur größer oder gleich der Siedetemperatur gehalten wird, wobei die Referenzeinrichtung (180, 180`) mit einem Drucksensor (190, 190`) zum Erfassen des Druckes in dem Referenzvolumen ausgestattet wird, wobei das Referenzvolumen über eine von einem schaltbaren Ventil (187, 187`) beherrschte Pumpleitung (185, 185') an eine Pumpeinrichtung (160) zur Erzeugung eines Unterdrucks in dem Referenzvolumen verbunden ist, wobei der auf einer kondensationsvermeidenden Temperatur gehaltene MFC (141, 142, 143) über eine von einem schaltbaren Ventilen (197, 197') beherrschte Referenzleitung (195, 195') an das Referenzvolumen angeschlossen wird, wobei das Referenzvolumen zunächst von der Pumpeinrichtung (160) auf einen Unterdruck gebracht wird und danach eine Druckanstiegsmessung ausgeführt wird, während über die Referenzleitung (195, 195') ein Grundgas in das Referenzvolumen strömt.

11. Verfahren nach Anspruch 10, **dadurch gekennzeichnet, dass** die Vorrichtung mit einem von Wänden umgebenden Warmbereich (120) ausgestattet wird, wobei wenigstens der MFC (141, 142, 143), der das aus einem flüssigen Ausgangsfluid entstandene Grundgas dosiert zum Mischmittel (171, 172, 173) führt, innerhalb dieses Warmbereiches (120) angeordnet wird, wobei der MFC bevorzugt dadurch auf der kondensationsvermeidenden Temperatur gehalten wird, indem der Warmbereich (120) auf einer kondensationsvermeidenden Temperatur gehalten wird, wobei bevorzugt auch die Referenzeinrichtung (180`) in diesem Warmbereich (120) angeordnet und dadurch auf der gewünschten kondensationsvermeidenden Temperatur gehalten wird.

12. Verfahren nach Anspruch 11, wobei ein weiteres Grundgas erzeugt wird durch Überführen eines zweiten flüssigen Ausgangsfluides in den gasförmigen Zustand, nämlich durch Erhitzen auf eine Temperatur oberhalb dessen Siedetemperatur, wobei alle MFC (141, 142, 143) in den Grundgasleitungen (124, 125) der aus den flüssigen Ausgangsfluiden entstandenen Grundgase im Warmbereich (120) angeordnet werden, und bevorzugt alle Steuerelektroniken (145) dieser MFC (141, 142, 143) außerhalb des Warmbereiches (120) angeordnet werden.

13. Verfahren nach einem der vorhergehenden Ansprüche 10-12, soweit auf Anspruch 11 rückbezogen, wobei mindestens ein weiteres Grundgas aus einer Gasquelle zugeführt wird, **dadurch gekennzeichnet, dass** alle MFC (146, 147, 148) in den Grundgasleitungen (102, 104), in denen Grundgase aus einer Gasquelle geführt sind, außerhalb des Warmbereiches (120) angeordnet werden.

14. Verfahren nach einem der vorhergehenden Ansprüche 10-13, soweit auf Anspruch 11 rückbezogen, **dadurch gekennzeichnet, dass** jeder MFC (141, 142, 143; 146, 147, 148) eine Steuerelektronik (145) aufweist, und die Steuerelektronik (145) des wenigstens einen im Warmbereich (120) angeordneten MFC (141, 142, 143) außerhalb des Warmbereiches (120) angeordnet wird.

15. Verfahren nach einem der vorhergehenden Ansprüche 10-14, insbesondere soweit auf Anspruch 11 rückbezogen, **dadurch gekennzeichnet, dass** die kondensationsvermeidende Temperatur, insbesondere die kondensationsvermeidende Temperatur im Warmbereich (120), wenigstens 5 °C über der Siedetemperatur gehalten wird.

16. Verfahren nach einem der vorhergehenden Ansprüche 10-15, **dadurch gekennzeichnet, dass** das Ausgangsfluid oder jedes der Ausgangsfluide mindestens auf 10 °C, bevorzugt mindestens 15 °C und weiter bevorzugt mindestens 20 °C oberhalb dessen Siedetemperatur aufgeheizt wird, wobei bevorzugt die kondensationsvermeidende Temperatur, insbesondere die kondensationsvermeidende Temperatur im Warmbereich (120), wenigstens 5 °C oberhalb dieser Aufheiztemperatur gehalten wird.

17. Verfahren nach einem der vorhergehenden Ansprüche 10-16, **dadurch gekennzeichnet, dass** die Vorrichtung (100) in wenigstens zwei unterschiedlichen Betriebsmodi betrieben wird, nämlich, einerseits in einem Produktionsmodus, in dem die Referenzeinrichtung (180, 180`) oder -einrichtungen nicht mit Gas beaufschlagt werden, aber Werkstücke beschichtet werden, und andererseits in einem Referenzmodus, in dem keine Werkstücke beschichtet werden, aber die Referenzeinrichtung (180, 180`) mit Gas beaufschlagt wird, indem die dahinführenden Referenzleitungen (195, 195`) nicht mehr dauerhaft geschlossen sind, sondern zur Ausführung einer Druckanstiegsmessung geeignet geöffnet und geschlossen werden.

18. Verfahren nach einem der vorhergehenden Ansprüche, **dadurch gekennzeichnet, dass** die Volumina der zur Anlage (10) verlaufenden prozessgasführenden Leitungen bestimmt werden, indem eine Druckanstiegsmessung in diese Prozessgasleitungen hinein ausgeführt wird, wobei das Ergebnis verglichen wird mit einer früheren, solchen Messung, insbesondere mit einer Messung bei der Inbetriebsetzung der Anlage.

19. Verfahren nach einem der vorhergehenden Ansprüche, **dadurch gekennzeichnet, dass** vor dem Ausführen der Druckanstiegsmessung, bei der über die Referenzleitung (195, 195`) ein Grundgas in das Referenzvolumen (180, 180') strömt, eine Leckratenmessung ausgeführt wird, indem der Druckanstieg im Referenzvolumen (180, 180') über eine Zeitdauer gemessen wird, ohne dass irgendeine zum Referenzvolumen (180, 180`) führende Leitung (185, 185', 195, 195`) geöffnet ist, und die Leckrate bei der Ermittlung des Flusses durch das MFC (141, 142, 143; 146, 147, 148) in das Referenzvolumen (180, 180`) berücksichtigt wird.
